# EUROPEAN PATENT APPLICATION

(11) **EP 1 104 907 A1**
(43) Date of publication of application: **06.06.2001**
(21) Application number: 00125447.3
(22) Date of filing: 20.11.2000
(51) Int. Cl.: G06K 7/00

(54) **Card reader for mounting to printed circuit board**

(30) Priority: 23.11.1999 KR 9952139
(71) Applicant: MOLEX INCORPORATED, Lisle Illinois 60532-1682 (US)
(72) Inventor: Shin, Hee-Seck, Kyunggi-Do (KR)
(74) Representative: Blumbach, Kramer & Partner GbR

(57) **Abstract**

Disclosed is a card reader connector (24) for mounting to an underlying printed circuit board (20) which is adapted to receive a storage medium in the form of an IC card (22). The card reader connector (24) comprises a body (30) including a lower plate (31) defining an opening (36) formed inwardly from one side thereof and sidewalls defining channels for guiding the IC card into insertion into the card reader connector. Solder tabs (37) adapted to be soldered to the printed circuit board are formed inwardly of the sidewalls toward the opening. A plurality of connection pins (40) are mounted on the lower plate of the body having a contact portion (41) at one end for contacting a corresponding contact of the IC card, and a soldering portion (42) at the other end located within the opening for solder connector to the printed circuit board. Because the solder tabs (37) and the soldering portions (42) of the connection pins are soldered to the printed circuit board within the area occupied by the body, the connector eliminates the printed circuit board areas previously occupied by the soldering of these features outside the connector body. and thus allows the overall size of the printed circuit board to be made smaller or more densely packaged, thereby contributing to the trend of more compact and slim electronic equipment.

## Description

### Field of the Invention

The present invention generally relates to a connector, and more particularly to an improved compact card reader connector for mounting to a printed circuit board, which card reader receives an IC card used in various portable electronic equipments and which, due to its design, occupies a smaller area when soldered to the underlying printed circuit board.

### Background of the Invention

Portable electronic equipment, such as a digital cameras, MP3 players and mobile phones, often employ a storage medium, such as a memory or peripheral program card, in and from which various data can be stored and deleted at any time.

Such a storage medium, for example an IC card using a flash memory, transmits or receives data through an underlying printed circuit board via a card reader connector soldered to the circuit board.

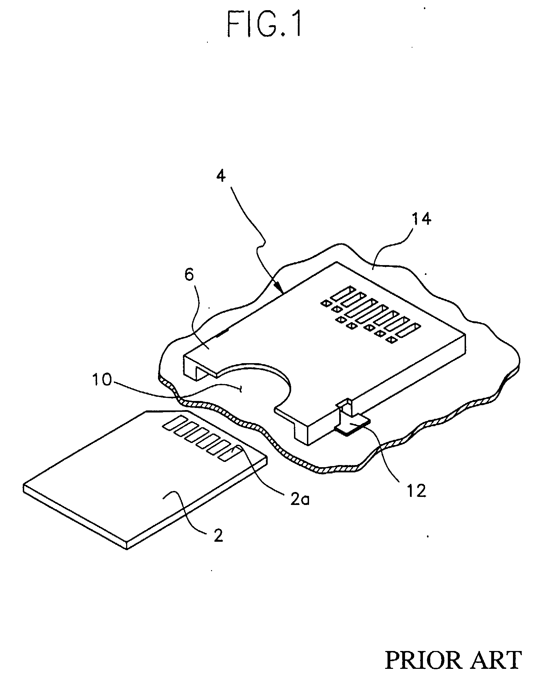

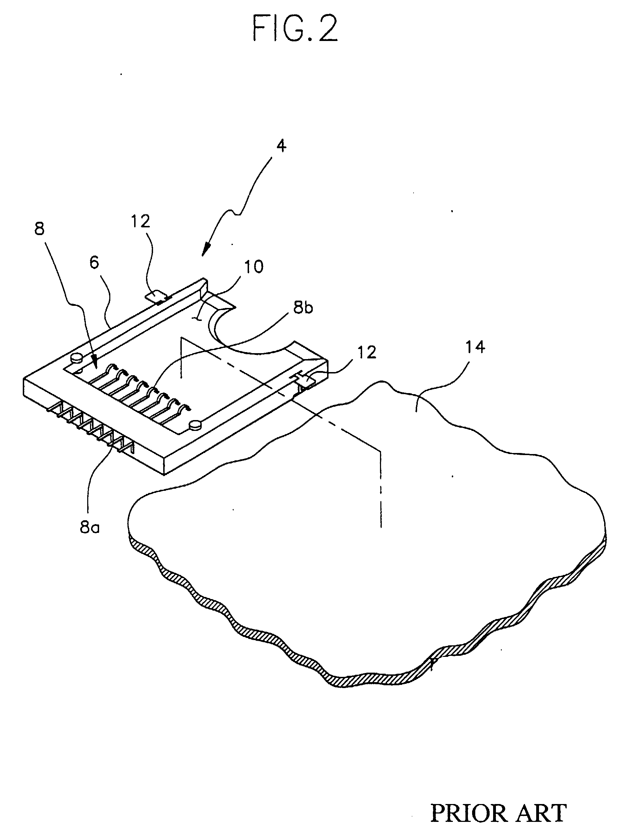

A known connector is shown in Figure 1 soldered to a printed circuit board, and FIG. 2 shows the same connector removed from the printed circuit board and exposed such that the internal structure thereof can be seen. In Figures 1 and 2, reference numeral "2" designates an IC card for being received in a connector 4 comprising a body 6 and a plurality of connection pins 8 mounted in the body. Body 6 is formed with a receiving space 10 for receiving IC card 2 and includes a plurality of through holes in the rear portion. Tabs 12 to be soldered to printed circuit board 14 are joined to outer surfaces of body 6 at a front portion thereof. As shown in Figure 2, each connection pin 8 includes a soldering portion 8a protruding rearwardly of body 6 and a contact portion 8b disposed in receiving space 10 for contact with a corresponding terminal 2a of IC card 2.

In this known connector, tabs 12 and soldering portions 8a are soldered to a surface of printed circuit board 14. In this way, tabs 12 and soldering portions 8a soldered to printed circuit board 14 occupy an area outside of body 6 on printed circuit board 14, and thus the area of printed circuit board 14 corresponding to the soldered regions are unusable for other components, effectively decreasing the effective mounting area of the printed circuit board. This result runs contrary to the trend toward more compact and slim electronic equipment and denser printed circuit board packaging.

### Summary of the Invention

Accordingly, the present invention has been made considering the above-stated problems, and it is an object of the present invention to provide an improved card reader for mounting to a printed circuit board, which conforms to the trend toward more compact and slim electronic equipment by reducing the area the connector occupies when soldered to the printed circuit board.

To achieve this object, there is provided an improved card reader connector for mounting to a printed circuit board, which receives a storage medium in the form of an IC card and is attached to the printed circuit board comprising:
a body (30) including sidewalls (32) defining C-shaped channels (35) for guiding the IC card into the card reader connector, and having an opening (36) between the channels at a front end thereof exposing a surface of the printed circuit board;
solder tabs (37) extending inwardly from the sidewalls into the opening (36) and adapted to contact and be soldered to a portion of the exposed surface of the printed circuit board; and
a plurality of connection pins (40) mounted in parallel on the body along a longitudinal axis thereof, each including a contact portion (41) at one end away adapted to contact a corresponding contact of the IC card, and a soldering portion (42) at the other end disposed within the opening and adapted to contact and be soldered to a portion of the exposed surface of the printed circuit board,
wherein the solder tabs and soldering portions of the connections pins are adapted to occupy areas of the printed circuit board defined by the body of the card reader connector.

Preferably, a rear guide for supporting an edge of a upper surface of the IC card is formed on a rear portion of the body.

Other objects and advantages of the present invention will be understood from the following description of an electric connector assembly according to a preferred embodiment of the invention in conjunction with the accompanying drawings.

### Brief Description of the Attached Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a perspective view of a conventional card reader connector shown soldered to an underlying printed circuit board and an IC card for insertion into the card reader;
FIGURE 2 is a bottom perspective view of the conventional card reader connector of Figure 1 removed from the printed circuit board and showing the internal structure of the connector; and
FIGURE 3 is a perspective view of the card reader connector according to the preferred embodiment of the invention soldered to the printed circuit board, together with the IC card for insertion into the card reader.

### Detailed Description of the Preferred Embodiment

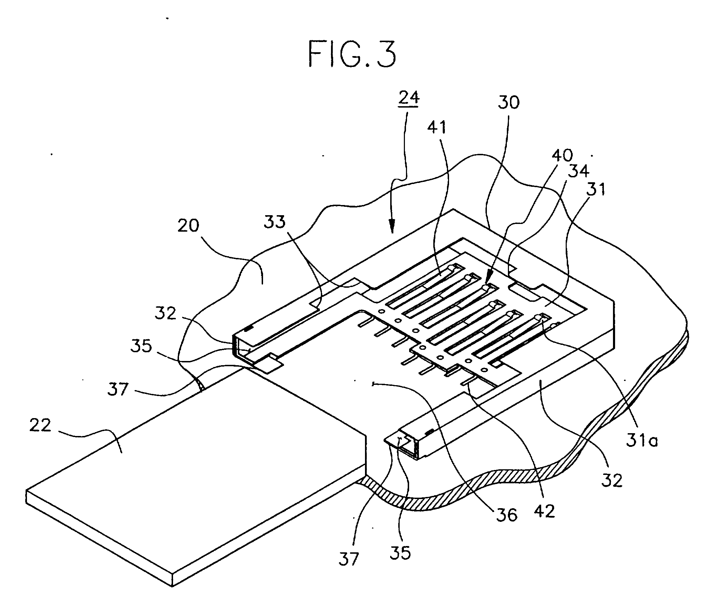

Figure 3 is a perspective view of a compact type connector according to the preferred embodiment of the present invention.

Reference numeral "20" designates a portion of a printed circuit board, and reference numeral "22" designates a storage medium, such as an IC card containing a flash memory. IC card 22 is provided with contacts (not shown) which are exposed one side of the IC card and are connected to the flash memory circuitry in the card.

The card reader connector 24 of the present invention includes a body 30 mounting a plurality of connection pins 40. The connection pins are mounted in parallel the body in a single row and extend generally parallel to the longitudinal axis of the card reader connector. Body 30 includes a lower plate 31, sidewalls 32 formed vertically on both opposite sides of lower plate 31, and side guides 33 and a rear guide 34 formed at the top of sidewalls 32 to define C-shaped channels 35 for guiding IC card 22 on both sides of body 30 into the card reader connector. Rear guide 34 also supports IC card 22 so as to prevent IC card 22 from being easily removed from card reader connector 24.

Body 30, including lower plate 31, is formed such that it defines an opening 36 which extends rearwardly from a front portion thereof to a middle portion of the connector, and is formed with a plurality of holes 31a which extend through lower plate 31 in a vertical direction. Lower plate 31 is also provided with a plurality of through holes (not shown) which connector holes 31a with opening 36 and into which a plurality of connection pins 40 as described below are inserted.

Front regions of opposite sidewalls 32 are formed with insertion grooves into and to which tabs 37 are inserted and joined. Tabs 37 are then bent toward opening 36 of lower plate 31 so that their distal ends protrude into opening 36. The protruding distal ends of tabs 37 are then soldered to printed circuit board 20.

Each connection pin 40 comprises a contact portion 41 adapted to be connected to a corresponding contact of IC card 22 and a soldering portion 42 adapted to be soldered to printed circuit board 20.

Each connection pin 40 is inserted into the through hole so that contact portion 41 is located in withdrawal hole 31a and soldering portion 42 is located in opening 36.

Contact portion 41 is formed slightly upward in its middle and end regions to establish a resilient force, so that a distal end of contact portion 41 protrudes above an upper surface of lower plate 41. Distal end of contact portion 41 is resiliently contacted by the corresponding contact of IC card 22 when IC card 22 is inserted into and positioned within body 30.

Soldering portion 42 located within opening 36 is bent downward from a region in which the through hole ends so that a lower surface of soldering portion 42 is positioned on the same plane as a lower surface of lower plate 31.

In the so constructed card reader connector 24, soldering portions 42 of connection pins 40 and tabs 37 are soldered to printed circuit board 20 such that lower plate 31 is closely contacted with printed circuit board 20. That is, since the soldered regions do not occupy an area of the printed circuit board outside the area defined by body 30, areas of printed circuit board 20 previously occupied by the soldering portions and the tabs, for example in the prior art connector shown in Figures 1 and 2, are available for the mounting of other components or features. Therefore the printed circuit board can be packaged more densely with more components or the printed circuit board can be made smaller contributing to the overall downsizing of the electronic apparatus within which the subject card reader is contained. When IC card 22 is initially received in connector 24, IC card 22 slides into connector 24 via channels 35 with the upper edges of IC card 22 being supported by side guides 33, and when IC card 22 is completely inserted into connector 24, each contact of IC card 22 is put into electrical and mechanical contact with a distal end of a corresponding contact portion 41 of connection pin 40.

As described hereinabove, the card reader connector for mounting to the printed circuit board according to the present invention substantially overcomes the problems of the conventional connector. Because the tabs and the soldering portions of the connection pins are soldered to the printed circuit board within the opening of the body, the connector configuration eliminates the areas of the printed circuit board previously occupied by these features, and thus allows the printed circuit board to be downsized as much as the areas eliminated, thereby contributing to the trend toward more compact and slim electronic equipments.

While the card reader connector for mounting to an underlying printed circuit board according to the present invention has been illustrated and described considering a preferred specific embodiment thereof, it will be understood by those skilled in the art that the present invention is not limited to the specific embodiment disclosed, and various changes, modifications and equivalents may be made without departing from the true scope of the present invention.

## Claims

1. A card reader connector (24) for mounting to a printed circuit board (20) and which receives an IC card (22), comprising:
a body (30) including sidewalls (32) having guides (33) defining C-shaped channels (35) for guiding the IC card into the card reader connector, and defining an opening (36) extending rearwardly between the channels from a front end thereof exposing a surface of the printed circuit board;
solder tabs (37) extending inwardly from the sidewalls into the opening (36) and adapted to contact and be soldered to a portion of the exposed surface of the printed circuit board; and
a plurality of connection pins (40) mounted in a single row on the body generally parallel to a longitudinal axis thereof, each including a contact portion (41) at one end away adapted to contact a corresponding contact of the IC card, and a soldering portion (42) at the other end disposed within the opening and adapted to contact and be soldered to a portion of the exposed surface of the printed circuit board,
wherein the solder tabs and soldering portions of the connections pins are adapted to occupy areas of the printed circuit board defined by the body of the card reader connector.

2. The card reader connector (24) for mounting to a printed circuit board (20) as set forth in claim 1 wherein the body (30) further comprises a lower plate (31) for mounting the connection pins (40) and which is configured to define the opening (36).

3. The card reader connector (24) for mounting to a printed circuit board as set forth in claim 2 wherein the lower plate includes holes (31a) through which the connection pins (40) extend.

4. The card reader connector (24) for mounting to a printed circuit board as set forth in claim 1 wherein the solder tabs (3) are positioned at a front end of the body on opposite sides thereof.

5. The card reader connector (24) for mounting to a printed circuit board as set forth in claim 1 wherein the solder tabs (37) extend inwardly from the sidewalls into the opening and the soldering portions (42) extend forward from the lower plate, whereby the solder tabs and soldering portions extend perpendicular to one another.

6. The card reader connector (24) for mounting to a printed circuit board as set forth in claim 1 wherein the body further comprises a rear guide (34) adapted for supporting a rear edge of an upper surface of the IC card formed on a rear portion of the body.
